# EUROPÄISCHE PATENTSCHRIFT

(11) **EP 1 286 858 B1**
(45) Veröffentlichungstag und Bekanntmachung des Hinweises auf die Patenterteilung: **28.07.2004**
(21) Anmeldenummer: 01933934.0
(22) Anmeldetag: 04.05.2001
(51) Int. Cl.: B60R 1/06

(54) **AUSSENSPIEGEL EINES KRAFTFAHRZEUGES**
EXTERNAL MIRROR ON A MOTOR VEHICLE
RETROVISEUR EXTERIEUR D'UN VEHICULE

(30) Priorität: 06.05.2000 DE 10022064
(43) Veröffentlichungstag der Anmeldung: 05.03.2003
(73) Patentinhaber: Bayerische Motoren Werke Aktiengesellschaft, 80809 München (DE)
(72) Erfinder: PETZOLD, Bernd, 82194 Groebenzell (DE)
(86) Internationale Anmeldenummer: PCT/EP2001/005067
(87) Internationale Veröffentlichungsnummer: WO 2001/085492

(56) Entgegenhaltungen:
- WO-A-00/70374
- DE-C- 19 724 725
- US-A- 4 915 493
- US-A- 5 166 825
- US-A- 5 315 442

## Beschreibung

Die Erfindung betrifft einen Außenspiegel eines Kraftfahrzeuges gemäß dem Oberbegriff des Anspruchs 1, wie z.B. aus US-A-5.315 442 bekannt ist.

Es ist bereits bekannt, dass Außenspiegel aus einer vom Kraftfahrzeug abstehenden Lage zum Fahrzeug hin verstellt werden können, um beispielsweise ohne eine Beschädigung des Außenspiegels durch eine Waschanlage fahren zu können.

Ferner ist es bekannt, in einem Gehäuse des Außenspiegels einen Spiegel so zu haltern, dass der Spiegel über einen elektrischen Antrieb in seiner Lage verstellbar ist. Die elektrische Versorgung erfolgt beispielsweise über eine sogenannte Leadframe-Technologie, bei der Leiterbahnen in eine Kunststoffplatte eingegossen sind. Die Leiterbahnen können beispielsweise aus Kupfer bestehen.

Um dieses Netzwerk aus Kupferbahnen mit einem Bussystem des Kraftfahrzeuges zu verbinden, werden Kabel an das Leadframe oder die Leiterplatte angelötet. Diese Kabel müssen nach der Montage eines Gelenkes an das Gehäuse des Außenspiegels durch eine Durchgangsöffnung in dem Gelenk und durch einen sich an das Gelenk anschließenden Spiegelfuß hindurchgeführt werden. Zur Verbindung mit einem beispielsweise in einem Hohlraum einer Fahrzeugtür eines Kraftfahrzeuges angeordneten Anschlusses, wie beispielsweise einer Steckdose, mussen an den Kabelenden dazu passende Stecker befestigt werden.

Bei dieser Bauweise ist nachteilig, dass das Anlöten der Kabel an die Leiterplatte, das Durchführen der Kabel durch das Spiegelgelenk und den Spiegelfuß und das Verbinden der Kabelenden mit einem Stecker, der nachfolgend in eine Steckdose gesteckt werden muß, zeitaufwendig ist.

Aufgabe der Erfindung ist es, einen Außenspiegel für ein Kraftfahrzeug zu schaffen, der einfach zu montieren ist.

Diese Aufgabe wird durch die Merkmale des Anspruchs 1 gelöst.

Bei dem erfindungsgemäßen Außenspiegel werden die an den Leadframe anzulötenden Kabel dadurch ersetzt, dass die Leiterbahnen der Leiterplatte zu einem länglichen Gebilde verlängert sind, das durch das Gelenk und den Spiegelfuß des Außenspiegels einfach hindurchführbar ist.

Zum Verstellen des Außenspiegels aus seiner Gebrauchslage in eine an die Karosserie des Kraftfahrzeuges angenäherte Lage sind die als Kabelersatz dienenden Leiterbahnen torsionsweich gestaltet, so dass die Leiterbahnen für die Verstellung des Außenspiegels ausreichend beweglich sind.

Eine torsionsweiche Gestaltung des Vertängerungsabschnittes der Leiterplatte erfolgt in einer vorteilhaften Ausführungsform dadurch, dass die Leiterbahnen mäanderförmig zumindest in dem Bereich angeordnet sind, in dem die Verstellbewegung des Außenspiegels erfolgt.

In einer vorteilhaften Ausführungsform weisen die verdrehbaren Leiterbahnen eine Wellenform auf. Durch diese Bauweise kann bei gleicher Torsionsweichheit der Bauraum verringert werden.

Die Isolierung der einzelnen Leiterbahnen voneinander erfolgt in einer vorteilhaften Ausführungsform dadurch, dass die Leiterbahnen durch einen isolierenden Kunststoff, wie beispielsweise einem elastischen Tauchlack, umhüllt sind. In einer anderen vorteilhaften Ausführungsform ist eine Isolierung nur an den Umkehrstellen so vorgesehen, dass die dort aufgebrachte Isolierung zusätzlich als ein Abstandshalter wirkt.

In einer vorteilhaften Ausführungsform sind die Enden der Leiterbahnen als ein Stecker ausgebildet.

Ausführungsformen der Erfindung werden nachstehend anhand der Figuren beispielshalber beschrieben. Dabei zeigen:
- Fig 1: einen Längsschnitt durch einen Außenspiegel eines Kraftfahrzeuges,
- Fig 2: eine Ansicht von oben auf eine erste Ausführungsform einer Verlängerung einer Leiterplatte und
- Fig 3: eine perspektivische Ansicht von der Seite auf eine zweite Ausführungsform einer Verlängerung der Leiterplatte.

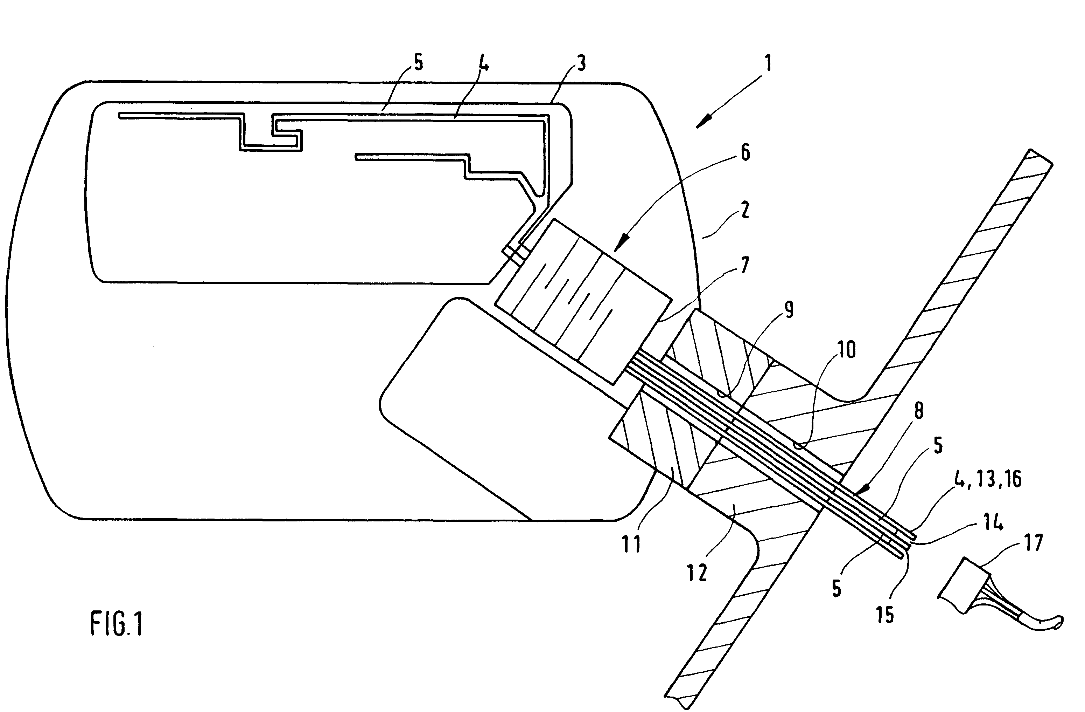

Die Fig. 1 zeigt einen Außenspiegel 1, der beispielsweise an einer Tür eines nicht dargestellten Kraftfahrzeuges befestigbar ist. Der Außenspiegel 1 weist ein Gehause 2 auf, in dem eine Leiterplatte oder ein Leadframe 3 befestigt ist. Die Leiterplatte 3 weist Leiterbahnen 4 auf, die in einen Kunststoff 5 eingegossen sind.

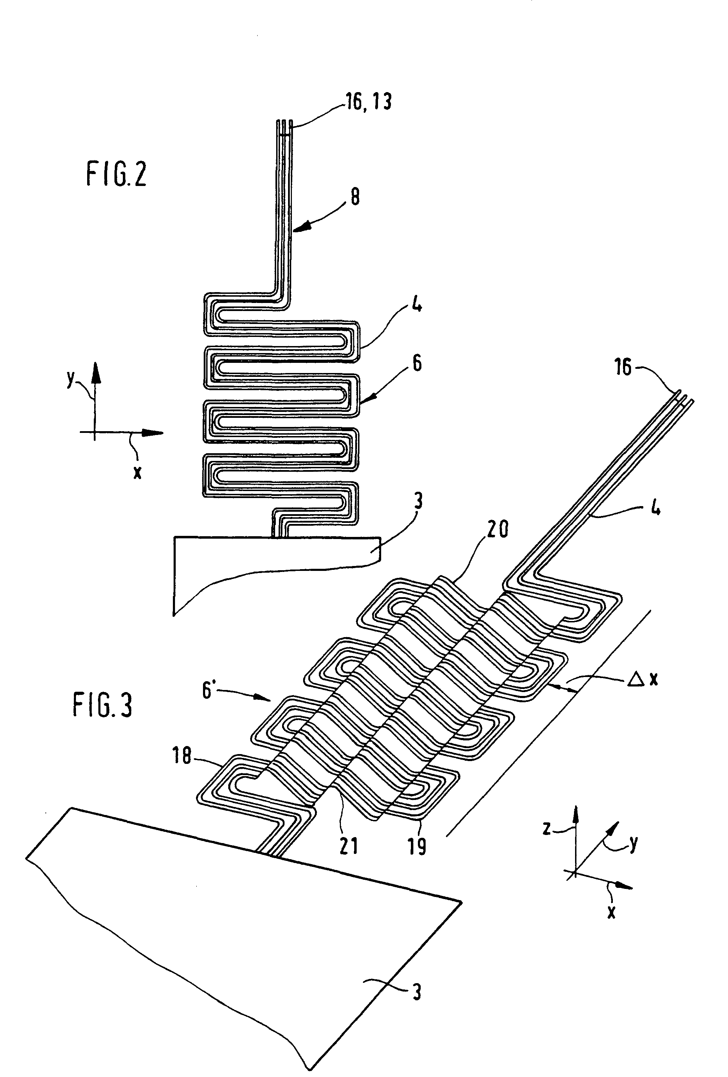

Mit der Leiterplatte 3 verbunden ist ein Abschnitt 6, in dem die von der Leiterplatte 3 kommenden Leiterbahnen 4 mäanderförmig angeordnet sind, wie dies in den Fig. 2 und 3 gezeigt ist, so dass in diesem Abschnitt 6 der Leiterplatte 3 die Leiterbahnen 4 torsionsweich sind. In dem Leiterplatten-Abschnitt 6 ist somit ein Abklappen oder Verdrehen des Außenspiegels 1 möglich.

An einem Ende 7 des Leiterplatten-Abschnittes 6 sind die Leiterbahnen 4 geradlinig und parallel zueinander in einem Abschnitt 8 angeordnet. Der Leiterplatten-Abschnitt 8 ist durch Durchgangsöffnungen 9 und 10 hindurchgeführt, die in einem Gelenk 11 und einem Spiegelfuß 12 ausgebildet sind.

In der gezeigten Ausführungsform sind die in der Fig. 1 gezeigten drei Leiterbahnen 4 über Kunststoff 5 voneinander isoliert gehaltert. Die freien Enden 13 der Leiterbahnen 4 weisen in den beiden Zwischenräumen 14 und 15 keinen Kunststoff 5 auf, so dass die freien Enden 13 der Leiterbahnen 4 als ein Stecker 16 verwendbar sind. Der Stecker 16 ist in einen beispielsweise als Steckdose ausgebildeten Anschluß 17 steckbar. Über den Anschluß 17 sind die Leiterbahnen 4 beispielsweise mit einem Bussystem des Kraftfahrzeuges verbunden.

Die Fig. 2 zeigt eine vergrößerte Darstellung des Leiterplatten-Abschnittes 6, aus dem der mäanderförmige Verlauf der Leiterbahnen 4 hervorgeht. In der Fig. 2 verlaufen die Leiterbahnen 4 in den Abschnitten 6 und 8 in einer horizontalen x - y-Ebene.

Der in der Fig. 3 gezeigte Leiterplatten-Abschnitt 6' unterscheidet sich von dem in der Fig. 2 gezeigten Leiterplatten-Abschnitt 6 dadurch, dass zusätzlich zu dem in der x-y-Ebene liegenden Endabschnitten 18 und 19 zwei Wellen oder Bögen 20 und 21 in z-Richtung ausgebildet sind. Durch die Bögen 20, 21 ergibt sich bei gleicher Torsionsweichheit in dem Leiterplatten-Abschnitt 6' eine Verkürzung Δx in der x-Richtung und somit eine Verringerung des Platzbedarfes des Leiterplatten-Abschnittes 6 in x-Richtung.

## Patentansprüche

1. Außenspiegel (1) für ein Kraftfahrzeug, der aus einer vom Kraftfahrzeug abstehenden Lage in eine an das Kraftfahrzeug angenäherte Lage verstellbar ist, mit einem Gehäuse (2) zur Aufnahme eines Spiegels, wobei das Gehäuse eine Leiterplatte (3) äufweist, in der in Kunststoff eingegossene Leiterbahne (4) ausgebildet sind, mit einem Gelenk (11) zum Verstellen des Außenspiegels, wobei das Gelenk (11) zwischen dem Gehäuse (2) des Außenspiegels und einem an der Karosserie befestigten Spiegelfuß (12) angeordnet ist und mit einer elektrischen Verbindung, die von der Leiterplatte zu einem im Kraftfahrzeug befindlichen Anschluß verläuft,
**dadurch gekennzeichnet, dass** die elektrische Verbindung aus verlängerten Abschnitten (6, 6'; 8) der Leiterplatte (3) besteht und dass zumindest ein Abschnitt (6, 6') dieser Verlängerung der Leiterplatte (3) so torsionsweich gestaltet ist, dass der Außenspiegel (1) in Richtung auf das Kraftfahrzeug und von diesem weg verstellbar ist.

2. Außenspiegel nach Anspruch 1,
**dadurch gekennzeichnet, dass** der torsionsweiche Abschnitt (6, 6') der Leiterplatte (3) aus mäanderförmig angeordneten Leiterbahnen (4) besteht.

3. Außenspiegel nach den Ansprüchen 1 oder 2,
**dadurch gekennzeichnet, dass** der torsionsweiche Abschnitt (6) der Leiterplatte (3) sich in einer Ebene erstreckt.

4. Außenspiegel nach einem der vorhergehenden Ansprüche,
**dadurch gekennzeichnet, dass** in dem torsionsweichen Abschnitt (6') der Leiterplatte (3) zusätzlich Krümmungen (20, 21) vorgesehen sind, die sich senkrecht zu dem mäanderförmigen Verlauf der Leiterbahnen (4) erstrecken.

5. Außenspiegel nach einem der vorhergehenden Ansprüche,
**dadurch gekennzeichnet, dass** sich an den torsionsweichen Abschnitt (6, 6') der Leiterplatte (3) ein Abschnitt (8) anschließt, bei dem die Leiterbahn (4) geradlinig und parallel zueinander verlaufen.

6. Außenspiegel nach einem der vorhergehenden Ansprüche,
**dadurch gekennzeichnet, dass** die Leiterbahnen (4) der Abschnitte (6, 6'; 8) der Leiterplatte (3) über die gesamte Länge oder nur teilweise durch einen Kunststoff (5) isoliert voneinander gehaltert sind.

7. Außenspiegel nach einem der vorhergehenden Ansprüche,
**dadurch gekennzeichnet, dass** bei dem torsionsweichen Abschnitt (6, 6') zumindest an den Endbereichen (18, 19) Kunststoffisolierungen (5) vorgesehen sind.

8. Außenspiegel nach einem der vorhergehenden Ansprüche,
**dadurch gekennzeichnet, dass** die freien Enden (13) der Leiterbahn (4) die Funktion eines Steckers (16) aufweisen.

## Claims

1. An external mirror (1) for a motor vehicle and movable from a position projecting from the vehicle into a position near the vehicle, comprising a mirror-holding casing (2), wherein the casing contains a circuit board (3) in which strip conductors (4) are embedded in plastics material, with a joint (11) for adjusting the external mirror, the joint (11) being disposed between the external-mirror casing (2) and a mirror base (12) fastened to the vehicle body, and with an electric connection from the circuit board to a connection in the vehicle, **characterised in that** the electric connection consists of elongated portions (6, 6'; 8) of the circuit board (3) and at least one portion (6, 6') of the elongated circuit board (3) is made flexible enough for the external mirror (1) to be movable towards and away from the vehicle.

2. An external mirror according to claim 1, **characterised in that** the flexible portion (6, 6') of the circuit board (3) is made up of strip conductors (4) arranged in a meander pattern.

3. An external mirror according to claims 1 and 2, **characterised in that** the flexible portion (6) of the circuit board (3) extends in a plane.

4. An external mirror according to any of the preceding claims, **characterised in that** the flexible portion (6') of the circuit board (3) is formed with additional bends (20, 21) at right angles to the meander shape of the strip conductors (4).

5. An external mirror according to any of the preceding claims, **characterised in that** the flexible portion (6, 6') of the circuit board (3) adjoins a portion (8) in which the strip conductors (4) are straight and parallel to one another.

6. An external mirror according to any of the preceding claims, **characterised in that** the strip conductors (4) in the portions (6, 6'; 8) of the circuit board (3) are insulated and held apart by a plastics material (5) over all or only part of their lengths.

7. An external mirror according to any of the preceding claims, **characterised in that** the flexible portion (6, 6') is insulated with plastics material (5) at least at the end regions (18, 19).

8. An external mirror according to any of the preceding claims, **characterised in that** the free ends (13) of the strip conductors (4) serve as a plug (16).

## Revendications

1. Rétroviseur extérieur (1) pour un véhicule automobile, mobile depuis une position éloignée du véhicule automobile jusque dans une position rapprochée du véhicule, comportant un boîtier (2) destiné à recevoir un rétroviseur, le boîtier présentant un circuit imprimé (3) dans lequel sont formées des pistes conductrices (4) scellées dans une matière synthétique, une articulation (11) destinée à déplacer le rétroviseur extérieur, l'articulation (11) étant disposée entre le boîtier (2) du rétroviseur extérieur et un pied de rétroviseur (12) fixé à la carrosserie, et une liaison électrique qui s'étend depuis le circuit imprimé jusqu'à un raccordement situé dans le véhicule,
**caractérisé en ce que**
la liaison électrique se compose de segments prolongés (6, 6' ; 8) du circuit imprimé (3) et au moins un segment (6, 6') de ce prolongement du circuit imprimé (3) est structuré pour se prêter à la torsion, de telle manière que le rétroviseur extérieur (1) est mobile en direction du véhicule automobile et dans le sens contraire.

2. Rétroviseur extérieur selon la revendication 1,
**caractérisé en ce que**
le segment (6, 6') - susceptible de torsion - du circuit imprimé (3) se compose de pistes conductrices (4) disposées en méandres.

3. Rétroviseur extérieur selon les revendications 1 ou 2,
**caractérisé en ce que**
le segment (6, 6') - susceptible de torsion - du circuit imprimé (3) s'étend dans un plan.

4. Rétroviseur extérieur selon l'une des revendications précédentes,
**caractérisé en ce que**
dans le segment (6, 6') - susceptible de torsion - du circuit imprimé (3), on prévoit en outre des courbures (20, 21) qui s'étendent perpendiculairement au tracé en méandres des pistes conductrices (4).

5. Rétroviseur extérieur selon l'une des revendications précédentes,
**caractérisé en ce qu'**
un segment (8) se raccorde au segment (6, 6') - susceptible de torsion - du circuit imprimé (3), les pistes conductrices (4) s'étendant en ligne droite et parallèlement les unes aux autres.

6. Rétroviseur extérieur selon l'une des revendications précédentes,
**caractérisé en ce que**
les pistes conductrices (4) des segments (6, 6' ; 8) du circuit imprimé (3) sont maintenues isolées les unes des autres sur toute la longueur, ou seulement sur une partie de celle-ci, au moyen d'une matière synthétique (5).

7. Rétroviseur extérieur selon l'une des revendications précédentes,
**caractérisé en ce que**
sur le segment (6, 6') susceptible de torsion, on prévoit au moins sur les segments terminaux (18, 19) des isolations (5) en matière synthétique.

8. Rétroviseur extérieur selon l'une des revendications précédentes,
**caractérisé en ce que**
les extrémités libres (13) de la piste conductrice (4) assument la fonction d'une prise mâle (16).
